# EUROPEAN PATENT APPLICATION

(11) **EP 0 989 607 A1**
(43) Date of publication of application: **29.03.2000**
(21) Application number: 99906263.1
(22) Date of filing: 09.03.1999
(51) Int. Cl.: H01L 23/482, H01L 23/62

(54) **IMPROVEMENTS TO THE PROTECTION OF FETs BY MEANS OF TRACKS OF PRINTED CIRCUIT BOARDS**

(30) Priority: 10.03.1998 ES 9800508
(71) Applicant: MECANISMOS AUXILIARES INDUSTRIALES S.A. M.A.I.S.A., E-43800 Valls, Tarragona (ES)
(72) Inventor: LLOP TOUS, Jordi, E-43800 Valls (ES); MESTIERI CLOTET, Antonino, E-43800 Valls (ES); PLANA BREY, Josep LLuis, E-43800 Valls (ES)
(74) Representative: Morgades Manonelles, Juan Antonio
(86) International application number: ES9900057
(87) International publication number: WO9946818

(57) **Abstract**

The present invention refers to special sizing of the circuit board conductive tracks so when a failure situation occurs, that is to say a short-circuit situation, they function themselves per se as a fuse, with no additional costs and without the need to incorporate any further parts to the circuit board tracks. For this reason, it has been designed a narrowing portion in the tracks which are associated to the Smart FET.

## Description

The present patent application relates, as stated in its title, to "IMPROVEMENTS IN THE PROTECTION OF FETS BY MEANS OF PCB TRACKS", which novel manufacturing, conformation and design features fulfil the purpose to which they have been specifically conceived, with a maximum safety and effectiveness.

More particularly, the present invention refers to the design of electronic circuit boards in the field of motor vehicles, wherein self-protected FETS (Smart FET) are included and there is not the possibility of protecting a failure mode in a short-circuit situation.

As a result of a possible failure or short-circuit situation, the whole system where FETS are included becomes unprotected, and it could be raised the possibility of a vehicle setting on fire, impairing both the electronic parts as well as wiring attached thereto.

The object of the present invention is to provide a solution to the above-mentioned problems that consists of special sizing of the circuit board conductive tracks so when a failure situation occurs, that is to say a short-circuit situation, they function themselves per se as a fuse, with no additional costs and without the need to incorporate any further parts to the circuit board tracks. For this reason, it has been designed a narrowing portion in the tracks which are associated to the Smart FET.

The advantages associated to the provided solution firstly entail an overall safety of the circuit manufactured according to the provided solution; they secondly entail a reduction in the production costs of an equivalent circuit, i.e. a circuit board with the above-mentioned parts, but wherein the sufficient parts had to be attached to said arrangement when taking into consideration the failure condition in order to prevent said problem.

In addition and thanks to the provided solution suitability, it does not entail an additional cost over what it can be considered the manufacturing cost of the circuit board with FETS protection itself.

Further details and features of the present patent application will be apparent from the following description, which refers to the accompanying drawings that schematically represent the preferred details. These details are given by way of example, which refer to a possible case of practical embodiment, but it is not limited to the details disclosed herein; therefore this description must be considered from a illustrating point of view and without any type of limitations.

A detailed list of the various parts cited in the present patent application is given below: (10) circuit board, (11) front face, (12) back face, (13) conductive tracks, (14) conductive tracks, (15) conductive tracks, (15a) narrowing portion, (16) dielectric support.

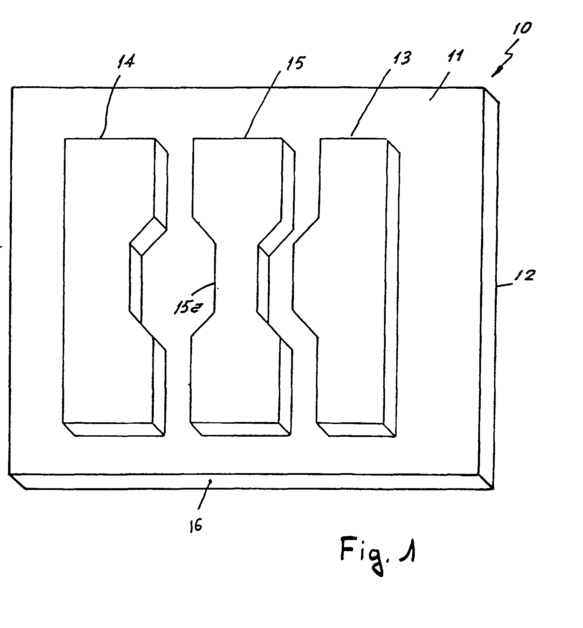

Figure n° 1 is a top plan view of a circuit board (10) provided with conductive tracks (13, 14, 15) which have been made by incorporating the protecting means of the present invention.

In one of the preferred embodiments of the object of the present invention and as it can be seen from the enclosed figure n° 1, the conventional circuit board (10) is essentially made up of dielectric support (16) in which front face (11) conductive tracks (13, 14, 15) are disposed according the suitable design, which function in collaboration with other electric and electronic parts not shown in the figure.

According to a preferred embodiment of the invention and in order to prevent short-circuit problems associated to self-protected FETS, one of the conductive tracks, e.g. track (15), has been designed with a narrowing portion (15a). This prevents destruction of the whole circuit board when overcurrent occurs as a consequence of a short-circuit situation thanks to the provision of said narrowing portion (15a). Narrowing (15a) is a function of a given overcurrent in such a way that material of the track (15) itself in the portion (15a) melts when reaching a critical value. This prevents from additional damage to the rest of the circuit board as well as from possible setting on fire of the whole electronic parts in the motor vehicle and even in some situations setting on fire of wiring itself.

Thanks to its suitability, the solution provided allows to be applied to any conductive track whichever are its path, size and thickness, only by calculating the narrowing portion, e.g. portion (15a), so that it is suitable to the admissible peak value of the current intensity running through any of the tracks. Said narrowing portion (15a) will be formed in any of the tracks of the circuit board (10) and therefore its location at a given point will neither entail any change of design nor functions nor circuits attached to the circuit board set (10).

On the other hand, the provided solution does not entail an additional cost increase of the production itself of the circuit board (10) as obtaining the narrowing portion (15a) does not entail any special operation apart of that in circuit board manufacturing conventional process, wherein precaution has only to be taken when designing the circuit boards along with the corresponding calculations of narrowing (15a) in any of the conductive tracks in the circuit board (10).

Once having been sufficiently described what the present patent application consists in accordance to the enclosed drawings, it is understood that any detail modification can be introduced as appropriate, provided that variations may alter the essence of the invention as summarised in the appended claims.

## Claims

1. "IMPROVEMENTS IN THE PROTECTION OF FETS BY MEANS OF PCB TRACKS" made up of dielectric support (16) in which front face (11) conductive tracks (13, 14, 15) are disposed, characterised in that any one of said conductive tracks (13, 14, 15) has a narrowing portion (15a) which length, width and thickness are a function of the maximum critical value of overcurrent which said conductive track (15) can withstand.
